(19) Europäisches Patentamt / European Patent Office / Office européen des brevets

(11) **EP 4 145 667 B1**

(12) **EUROPEAN PATENT SPECIFICATION**

(45) Date of publication and mention
of the grant of the patent:
**27.08.2025   Bulletin 2025/35**

(21) Application number: **21846966.6**

(22) Date of filing: **21.07.2021**

(51) International Patent Classification (IPC):
*H02J 7/00* (2006.01)    *H01M 10/48* (2006.01)
*H01M 10/42* (2006.01)    *G01R 31/385* (2019.01)
*G01R 31/387* (2019.01)    *G01R 31/367* (2019.01)
*B60L 58/18* (2019.01)

(52) Cooperative Patent Classification (CPC):
**G01R 31/389; B60L 58/12; B60L 58/16;
B60L 58/21; G01R 31/387; H01M 10/4207;
H01M 10/482; H02J 7/0013; H02J 7/0048;**
B60L 2200/12; B60L 2240/545; B60L 2240/547;
H01M 2010/4278; H01M 2220/20; Y02T 10/70;
(Cont.)

(86) International application number:
**PCT/KR2021/009448**

(87) International publication number:
**WO 2022/019664 (27.01.2022 Gazette 2022/04)**

(54) **APPARATUS AND METHOD FOR CONTROLLING POWER OF PARALLEL MULTI PACK MODULE**

VORRICHTUNG UND VERFAHREN ZUR STEUERUNG DER AUSGABE EINES PARALLELEN MEHRSTÜCKMODULS

DISPOSITIF ET PROCÉDÉ DE COMMANDE DE SORTIE DE MODULE MULTI-BLOC PARALLÈLE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:   **21.07.2020   KR 20200090585**

(43) Date of publication of application:
**08.03.2023   Bulletin 2023/10**

(73) Proprietor: **LG Energy Solution, Ltd.
Seoul 07335 (KR)**

(72) Inventor: **KO, Young-Jun
Daejeon 34122 (KR)**

(74) Representative: **Plasseraud IP
104 Rue de Richelieu
CS92104
75080 Paris Cedex 02 (FR)**

(56) References cited:
JP-A- 2010 164 329        KR-A- 20160 094 882
KR-A- 20170 096 409       KR-A- 20180 114 156
US-A1- 2018 026 311       US-A1- 2018 375 177
US-A1- 2020 185 944

(52) Cooperative Patent Classification (CPC): (Cont.)
Y02T 90/16

**Description**

TECHNICAL FIELD

The present disclosure relates to a power control apparatus and method, and more particularly, to a power control apparatus and method capable of preventing overcharge or overdischarge of a battery pack having a relatively low resistance in a parallel multi pack module in which a plurality of battery packs are connected in parallel.

The present application claims priority to Korean Patent Application No. 10-2020-0090585 filed on July 21, 2020 in the Republic of Korea.

BACKGROUND ART

The application field of batteries is gradually increasing not only to mobile devices such as cellular phones, laptop computers, smart phones and smart pads, but also electric-driven vehicles (EVs, HEVs, PHEVs), large-capacity energy storage systems (ESS), or the like.

A battery module mounted to an electric-driven vehicle includes an n number of battery packs connected in parallel to secure a high energy capacity, and each battery pack includes a plurality of battery cells connected in series. Hereinafter, the module in which the n number of battery packs are connected in parallel will be referred to as a parallel multi pack module.

In this specification, the battery cell may include one unit cell or a plurality of unit cells connected in parallel. The unit cell refers to one independent cell that has a negative electrode terminal and a positive electrode terminal and is physically separable. For example, one pouch-type lithium polymer cell may be regarded as a unit cell.

The total power of the parallel multi pack module is determined based on a battery pack with a lowest available power among the battery packs connected in parallel for safety. That is, the value obtained by multiplying a minimum available power among the available power values of the battery packs by the number of battery packs becomes a total power of the parallel multi pack module.

For example, in a parallel multi pack module in which five battery packs are connected in parallel, if the available powers of the five battery packs are 1 kW, 2 kW, 3 kW, 4 kW and 5 kW, respectively, the total power of the parallel multi pack module becomes is 5*1 kW (5 kW).

A management apparatus of the parallel multi pack module provides information on the total power (5 kW) to a control system of the electric-driven vehicle. Then, the control system adaptively distributes the power supplied to an inverter or a DC/DC converter and the power supplied to an ADAS (Advanced Driver Assistance System) unit, which supports functions of lane departure prevention, front collision warning or the like, and an electrical equipment unit so that the power consumed by the electric-driven vehicle does not exceed 5 kW. In this way, the power is distributed within the range of total power provided by the management apparatus of the parallel multi pack module, which is called a power guideline.

Meanwhile, when the total power of the parallel multi pack module is $P_{total}$, a pack power ($P_k$) of each battery pack is automatically distributed by a resistance ratio $R_{total}/R_{pack,k}$ between a pack resistance ($R_{pack,k}$) of the corresponding battery pack and a total resistance ($R_{total}$) of the parallel multi pack module according to the circuit theory. That is, the pack power ($P_{pack,k}$) of each battery pack is $P_{total}*R_{total}/R_{pack,k}$. Here, k is an index of the battery pack.

Since the pack power ($P_{pack,k}$) is determined not by an available power of the corresponding battery pack but by the total power ($P_{total}$) and the resistance ratio $R_{total}/R_{pack,k}$, as the pack resistance ($R_{pack,k}$) is lower, the pack power ($P_{pack,k}$) increases. Accordingly, as the pack power ($P_{pack,k}$) of the battery pack having a low pack resistance ($R_{pack,k}$) increases over the available power, the corresponding battery pack may be overcharged or overdischarged.

US2020/185944 A1 relates to a system of controlling an output of a high voltage battery for an eco-friendly vehicle that includes: the high voltage battery mounted in the eco-friendly vehicle; a storage configured to store information on maximum available charge and discharge power according to a temperature and a state of charge (SOC) of the high voltage battery; and a controller configured to control available charge power and available discharge power of the high voltage battery based on at least one of information on a charge duration and a discharge duration of the high voltage battery, information on an accumulated charge amount and an accumulated discharge amount of the high voltage battery, and information on a requested output amount of the vehicle.

US2018/026311 A1 relates to a method for operating at least two battery cells, which are electrically connected in parallel, of a battery for a motor vehicle. Each of the battery cells is provided with a galvanic element with two electrodes and a battery cell housing for accepting the galvanic element with two connections, and each of the electrodes is electrically coupled to a respective connection of the battery cell. A value of a state variable of each of the battery cells is measured, the values are compared to one another, and when there is a deviation of the values from each other which is outside of a predetermined tolerance range, an electric resistance is adjusted so that the deviation is within the predetermined tolerance range.

DISCLOSURE

Technical Problem

The present disclosure is designed to solve the problems of the related art, and therefore the present disclosure is directed to providing an apparatus and method for controlling power of a parallel multi pack module, which may prevent a pack power of a battery pack having a lowest resistance from exceeding an available power to cause overcharge or overdischarge, in determining a total power of a parallel multi pack module.

Technical Solution

In one aspect of the present disclosure, there is provided an apparatus according to claim 1.
According to an embodiment, the operation characteristic values may further include measured voltage values of the first to $n^{th}$ battery packs. In this embodiment, the multi pack management unit may be configured to determine pack resistances of the first to $n^{th}$ battery packs from the measured current values and the measured voltage values of the first to $n^{th}$ battery packs, determine an available power corresponding to the pack resistance with reference to a predetermined pack resistance-available power look-up table for each battery pack, and determine a minimum value among the available powers as the minimum available power.
According to another embodiment, the multi pack management unit may be configured to periodically receive a measured voltage value and a measured current value of each battery pack from the first to $n^{th}$ sensor units, and determine an average ratio of a voltage change to a current change calculated from the measured current values and the measured voltage values of the first to $n^{th}$ battery packs by means of linear regression analysis as the pack resistance of the first to $n^{th}$ battery packs.
According to still another embodiment, the multi pack management unit may be configured to determine a state of charge (SOC) of the first to $n^{th}$ battery packs based on the operation characteristic value of each battery pack received from the first to $n^{th}$ sensor units, determine an available power corresponding to the SOCs of the first to $n^{th}$ battery packs with reference to a predefined SOC-available power look-up table, and determine a minimum value among the available powers as the minimum available power.
Preferably, the multi pack management unit may be configured to calculate the total power ($P_{total}$) of the parallel multi pack module using the following equation.

$$P_{total} = min(P_{pack,k}) * I_{total} / max(I_{pack,k})$$

(k is an integer from 1 to n; $min(P_{pack,k})$ corresponds to a minimum available power among the available powers of the first to $n^{th}$ battery packs; $I_{total}$ corresponds to a summed current value for the measured current values of the first to $n^{th}$ battery packs; and $max(I_{pack,k})$ corresponds to a maximum current value among the measured current values of the first to $n^{th}$ battery packs)
According to still another embodiment, the apparatus for controlling power of a parallel multi pack module according to the present disclosure may further comprise a communication unit interposed between the multi pack management unit and the power management unit.
According to still another embodiment, the parallel multi pack module may be mounted to an electric-driven vehicle, and the power management unit may be included in a control system of the electric-driven vehicle.
In another aspect of the present disclosure, there is also provided a battery management system or an electric driving mechanism, comprising the apparatus for controlling power of a parallel multi pack module as described above.
In another aspect of the present disclosure, there is also provided a method for according to claim 10.
According to an embodiment, the operation characteristic values may further include measured voltage values of the first to $n^{th}$ battery packs, and the step (b) may include: (b1) determining pack resistances of the first to $n^{th}$ battery packs from the measured current values and the measured voltage values of the first to $n^{th}$ battery packs, (b2) determining an available power corresponding to the pack resistance with reference to a predetermined pack resistance-available power look-up table for each battery pack, and (b3) determining a minimum value among the available powers as the minimum available power.
According to another embodiment, the step (b) may include: (b1) periodically receiving a measured voltage value and a measured current value of each battery pack from the first to $n^{th}$ sensor units, and (b2) determining an average ratio of a voltage change to a current change calculated from the measured current values and the measured voltage values of the first to $n^{th}$ battery packs by means of linear regression analysis as the pack resistance of the first to $n^{th}$ battery packs.
According to still another embodiment, the step (b) may include: (b1) determining a SOC of the first to $n^{th}$ battery packs based on the operation characteristic value of each battery pack received from the first to $n^{th}$ sensor units, (b2) determining an available power corresponding to the SOCs of the first to nth battery packs with reference to a predefined SOC-available power look-up table, and (b3) determining a minimum value among the available powers as the minimum available power.

Preferably, in the step (d), the total power ($P_{total}$) of the parallel multi pack module may be calculated using the following equation.

$$P_{total} = min(P_{pack,k}) * I_{total} / max(I_{pack,k})$$

(k is an integer from 1 to n; $min(P_{pack,k})$ corresponds to a minimum available power among the available powers of the first to nth battery packs; $I_{total}$ corresponds to a summed current value for the measured current values of the first to nth battery packs; and $max(I_{pack,k})$ corresponds to a maximum current value among the measured current values of the first to nth battery packs)

Advantageous Effects

According to the present disclosure, the total power of the parallel multi pack module is adjusted so that the pack power of the battery pack having a low resistance among the battery packs included in the parallel multi pack module becomes identical to a minimum available power among available powers of the battery packs, thereby preventing the battery pack having a low resistance from being overcharged or overdischarged. As a result, safety and reliability may be improved when the parallel multi pack module is charged or discharged.

DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 is a block diagram showing a configuration of an apparatus for controlling power of a parallel multi pack module according to an embodiment of the present disclosure.
FIG. 2 shows an example of a pack resistance-available power look-up table according to an embodiment of the present disclosure.
FIG. 3 is a graph showing an example of an I-V profile in determining a pack resistance of a battery pack according to an embodiment of the present disclosure.
FIG. 4 is a flowchart for illustrating a method for controlling power of a parallel multi pack module according to an embodiment of the present disclosure.
FIG. 5 is a block diagram showing a battery management system that includes the apparatus for controlling power of a parallel multi pack module according to an embodiment of the present disclosure.
FIG. 6 is a block diagram showing an electric driving mechanism that includes the apparatus for controlling power of a parallel multi pack module according to an embodiment of the present disclosure.

BEST MODE

In the embodiments described below, a battery cell refers to a lithium secondary battery such as a lithium polymer battery. Here, the lithium secondary battery collectively refers to a secondary battery in which lithium ions act as operating ions during charging and discharging to cause an electrochemical reaction at a positive electrode and a negative electrode.

Meanwhile, even if the name of the secondary battery changes depending on the type of electrolyte or separator used in the lithium secondary battery, the type of packaging material used to package the secondary battery, and the interior or exterior structure of the lithium secondary battery, as long as lithium ions are used as operating ions the secondary battery should be interpreted as being included in the category of the lithium secondary battery.

The present disclosure may also be applied to other secondary batteries other than the lithium secondary battery. Therefore, even if the operating ions are not lithium ions, any secondary battery to which the technical idea of the present disclosure may be applied should be interpreted as being included in the category of the present disclosure regardless of its type.

In addition, it should be noted in advance that the battery cell may refer to one unit cell or a plurality of unit cells connected in parallel.

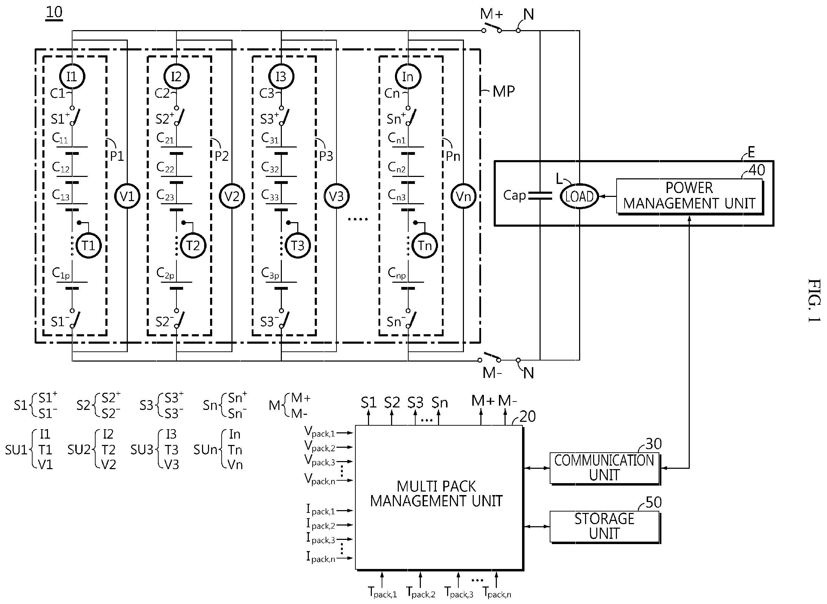

FIG. 1 is a block diagram showing a configuration of an apparatus for controlling power of a parallel multi pack module (hereinafter, also referred to as a power control apparatus) according to an embodiment of the present disclosure.

Referring to FIG. 1, a power control apparatus 10 according to an embodiment of the present disclosure is a device for controlling a power of a parallel multi pack module MP in which a plurality of battery packs P1 to Pn are connected in parallel, and the power control apparatus 10 adaptively controls a total power ($P_{total}$) of the parallel multi pack module MP to prevent some of the battery packs having relatively low pack resistance from being overcharged or overdischarged.

Preferably, the parallel multi pack module MP may include first to $n^{th}$ battery packs P1 to Pn that are connected in parallel through first to $n^{th}$ switch units S1 to Sn.

The parallel multi pack module MP may be connected to a load L through an external switch unit M. The external switch unit M includes an external high-potential switch M+ and an external low-potential switch M-. The external high-potential switch M+ and the external low-potential switch M- may be relay switches or power semiconductor switches, but the present disclosure is not limited thereto.

If the external high-potential switch M+ and the external low-potential switch Mare turned on, the parallel multi pack module MP is electrically connected to the load L. Conversely, when the external high-potential switch M+ and the external low-potential switch M- are turned off, the electrical connection between the parallel multi pack module MP and the load L is released.

The power control apparatus 10 of the parallel multi pack module MP receives a control command for charging start, charging end, discharging start or discharging end from a control device that controls the load L, and controls turn-on or turn-off operation of the external switch unit M according to the control command.

Preferably, the parallel multi pack module MP may be mounted to an electric-driven vehicle E, but the present disclosure is not limited thereto. The electric-driven vehicle E refers to a vehicle that can be driven by a motor, such as an electric vehicle, a plug-in hybrid vehicle or a hybrid electric vehicle.

The load L is a device that receives power from the parallel multi pack module MP, and may be an inverter included in an electric-driven vehicle E as an example. The inverter is a power conversion circuit that is installed at a front end of an electric motor of the electric-driven vehicle E to convert a DC current supplied from the parallel multi pack module MP into a 3-phase AC current and supplies the 3-phase AC current to the electric motor.

The load L may also be a DC/DC converter. The DC/DC converter is a power conversion circuit that converts a voltage of a DC current supplied from the parallel multi pack module MP into a drive voltage of an electric equipment unit of the electric-driven vehicle E or a drive voltage of an ADAS and then applies the converted voltage to the electric equipment unit or the ADAS.

In the present disclosure, the type of the load L is not limited to the inverter or the DC/DC converter, and any device or instrument capable of receiving power from the parallel multi pack module MP may be included in the category of the load L regardless of its type.

In the present disclosure, each of the first to $n^{th}$ battery packs P1 to Pn includes a plurality of battery cells connected in series therein. That is, the first battery pack P1 includes first to $p^{th}$ battery cells $C_{11}$ to $C_{1p}$ connected in series. In addition, the second battery pack P2 includes first to $p^{th}$ battery cells $C_{21}$ to $C_{2p}$ connected in series. In addition, the third battery pack P3 includes first to $p^{th}$ battery cells $C_{31}$ to $C_{3p}$ connected in series. In addition, the $n^{th}$ battery pack Pn includes first to $p^{th}$ battery cells $C_{n1}$ to $C_{np}$ connected in series. Though fourth to $n-1^{th}$ battery packs are not shown in the drawing, they also include a p number of battery cells connected in series in the same manner as the illustrated battery packs.

Each of the first to $n^{th}$ battery packs P1 to Pn includes the switch units S1 to Sn therein. That is, the first battery pack P1 includes a first switch unit S1. In addition, the second battery pack P2 includes a second switch unit S2. In addition, the third battery pack P3 includes a third switch unit S3. In addition, the $n^{th}$ battery pack Pn includes an $n^{th}$ switch unit Sn. Though the fourth to $n-1^{th}$ battery packs are not shown in the drawing, they also include a switch unit in the same manner as the illustrated battery packs.

Each of the first to $n^{th}$ switch units S1 to Sn includes a low-potential switch and a high-potential switch. That is, the first switch unit S1 includes a first high-potential switch $S1^+$ installed at a high-potential side of the first battery pack P1 and a first low-potential switch $S1^-$ installed at a low-potential side of the first battery pack P1. In addition, the second switch unit S2 includes a second high-potential switch $S2^+$ installed at a high-potential side of the second battery pack P2 and a second low-potential switch $S2^-$ installed at a low-potential side of the second battery pack P2. In addition, the third switch unit S3 includes a third high-potential switch $S3^+$ installed at a high-potential side of the third battery pack P3 and a third low-potential switch $S3^-$ installed at a low-potential side of the third battery pack P3. In addition, the $n^{th}$ switch unit Sn includes an $n^{th}$ high-potential switch $Sn^+$ installed at a high-potential side of the $n^{th}$ battery pack Pn and an $n^{th}$ low-potential switch $Sn^-$ installed at a low-potential side of the $n^{th}$ battery pack Pn. Meanwhile, though the fourth to $n-1^{th}$ battery packs are not shown in the drawing, they also include a high-potential switch and a low-potential switch in the same manner as the illustrated battery pack. In addition, in each switch unit, any one of the high-potential switch and the low-potential switch may be omitted.

In the following disclosure, when the switch unit is turned on, the low-potential switch may be turned on first and the high-potential switch may be turned on later. Also, when the switch unit is turned off, the high-potential switch may be turned off first and the low-potential switch may be turned off later.

Preferably, the switch employed at the first to $n^{th}$ switch units S1 to Sn may be a relay switch. As an alternative, the first to $n^{th}$ switch units S1 to Sn may be a semiconductor switch such as a MOSFET or a power semiconductor switch, but the present disclosure is not limited thereto.

A capacitor Cap is provided at a front end of the load L. The capacitor Cap is connected in parallel between the parallel multi pack module MP and the load L. The capacitor Cap functions as a filter to prevent a noise current from being applied toward the load L or the parallel multi pack module MP.

The power control apparatus 10 according to the present disclosure includes first to $n^{th}$ current sensors I1 to In. The first to $n^{th}$ current sensors I1 to In are installed on power lines C1 to Cn connected to the first to $n^{th}$ battery packs P1 to Pn, respectively, to measure a current value flowing through the power lines C1 to Cn.

That is, the first current sensor I1 outputs a measured current value ($I_{pack,1}$) of the first battery pack P1 flowing through the first power line C1 included in the first battery pack P1. In addition, the second current sensor I2 outputs a measured current value ($I_{pack,2}$) of the second battery pack P2 flowing through the second power line C2 included in the second battery pack P2. In addition, the third current sensor I3 outputs a measured current value ($I_{pack,3}$) of the third battery pack P3 flowing through the third power line C3 included in the third battery pack P3. In addition, the $n^{th}$ current sensor In outputs a measured current value ($I_{pack,n}$) of the $n^{th}$ battery pack Pn flowing through the $n^{th}$ power line Cn included in the $n^{th}$ battery pack Pn. Although not shown in the drawing, the fourth to $n\text{-}1^{th}$ current sensors output measured current values flowing through the fourth to $n\text{-}1^{th}$ power lines included in the fourth to $n\text{-}1^{th}$ battery packs, respectively.

In the drawing, it is shown that first to $n^{th}$ current sensors I1 to In are included in the battery packs, respectively. However, in the present disclosure, the first to $n^{th}$ current sensors I1 to In may also be installed outside the battery packs, without limitation.

The first to $n^{th}$ current sensors I1 to In may be Hall sensors. The Hall sensor is a known current sensor that outputs a voltage signal corresponding to the magnitude of a current. In another example, the first to $n^{th}$ current sensors I1 to In may be sense resistors. If the voltage applied to both ends of the sense resistor is measured, the magnitude of current flowing through the sense resistor may be determined using Ohm's law. In other words, if the magnitude of the measured voltage is divided by a known resistance value of the sense resistor, the magnitude of current flowing through the sense resistor may be determined.

The power control apparatus 10 according to an embodiment of the present disclosure also includes first to $n^{th}$ voltage sensors V1 to Vn. The first voltage sensor V1 outputs a measured voltage value ($V_{pack,1}$) of the first battery pack P1 corresponding to a potential difference between the positive electrode and the negative electrode of the first battery pack P1. In addition, the second voltage sensor V2 outputs a measured voltage value ($V_{pack,2}$) of the second battery pack P2 corresponding to a potential difference between the positive electrode and the negative electrode of the second battery pack P2. In addition, the third voltage sensor V3 outputs a measured voltage value ($V_{pack,3}$) of the third battery pack P3 corresponding to a potential difference between the positive electrode and the negative electrode of the third battery pack P3. In addition, the $n^{th}$ voltage sensor Vn outputs a measured voltage value ($V_{pack,n}$) of the $n^{th}$ battery pack corresponding to a potential difference between the positive electrode and the negative electrode of the $n^{th}$ battery pack Pn. Although not shown in the drawing, the fourth to $n\text{-}1^{th}$ voltage sensors output measured voltage values of the fourth to $n\text{-}1^{th}$ battery packs, respectively.

The first to $n^{th}$ voltage sensors V1 to Vn include a voltage measurement circuit such as a differential amplifier circuit. Since the voltage measurement circuit is well known in the art, the voltage measurement circuit will not be described in detail here.

The power control apparatus 10 according to an embodiment of the present disclosure also includes first to $n^{th}$ temperature sensors T1 to Tn. The first temperature sensor T1 outputs a measured temperature value ($T_{pack,1}$) of the first battery pack P1 indicating a surface temperature of a cell located at a predetermined position, for example at a center, of the first battery pack P1. In addition, the second temperature sensor T2 outputs a measured temperature value ($T_{pack,2}$) of the second battery pack P2 indicating a surface temperature of a cell located at a predetermined position, for example at a center, of the second battery pack P2. In addition, the third temperature sensor T3 outputs a measured temperature value ($T_{pack,3}$) of the third battery pack P3 indicating a surface temperature of a cell located at a predetermined position, for example at a center, of the third battery pack P3. In addition, the $n^{th}$ temperature sensor Tn outputs a measured temperature value ($T_{pack,n}$) of the $n^{th}$ battery pack Pn indicating a surface temperature of a cell located at a predetermined position, for example at a center, of the $n^{th}$ battery pack Pn. Although not shown in the drawing, the fourth to $n\text{-}1^{th}$ temperature sensors output measured temperature values of the fourth to $n\text{-}1^{th}$ battery packs, respectively.

In the present disclosure, the first current sensor I1, the first voltage sensor V1 and the first temperature sensor T1 constitute a first sensor unit SU1. In addition, the second current sensor I2, the second voltage sensor V2 and the second temperature sensor T2 constitute a second sensor unit SU2. In addition, third current sensor I3, the third voltage sensor V3 and the third temperature sensor T3 constitute a third sensor unit SU3. In addition, the $n^{th}$ current sensor In, the $n^{th}$ voltage sensor Vn and the $n^{th}$ temperature sensor Tn constitute an $n^{th}$ sensor unit SUn. Although not shown in the drawing, the fourth to $n\text{-}1^{th}$ sensor units also include a current sensor, a voltage sensor and a temperature sensor, respectively.

In some cases, it is obvious that the first to $n^{th}$ sensor units SU1 to SUn may further include sensors for measuring other operating characteristics of the battery pack in addition to the sensors for measuring current, voltage and temperature.

Preferably, the power control apparatus 10 according to an embodiment of the present disclosure also includes a multi pack management unit 20 operatively coupled to the first to n$^{th}$ switch units S1 to Sn and the first to n$^{th}$ sensor units SU1 to SUn.

The multi pack management unit 20 may be operatively coupled with a power management unit 40 of the electric-driven vehicle E, which manages the power consumed in the load L. As a control element provided to a control system included in the electric-driven vehicle E, the power management unit 40 may adaptively manage the magnitude of power consumed in the load L to be suitable for the total power of the parallel multi pack module MP. Here, the total power means a total discharging power of the parallel multi pack module MP.

In the present disclosure, the load L may be replaced with a charging device. In this case, the power management unit 40 may adaptively manage a charging power supplied to the parallel multi pack module MP to be suitable for the total power of the parallel multi pack module MP. Here, total power means a total charging power provided to the parallel multi pack module MP.

Preferably, the power control apparatus 10 according to an embodiment of the present disclosure may further include a communication unit 30 interposed between the multi pack management unit 20 and the power management unit 40. The communication unit 30 forms a communication interface between the multi pack management unit 20 and the power management unit 40.

In the present disclosure, any known communication interface that supports communication between two different communication media may be used as the communication interface. The communication interface may support wired or wireless communication. Preferably, the communication interface may support CAN communication, daisy chain communication, RS 232 communication, or the like.

If a discharging request is received from the power management unit 40 of the electric-driven vehicle E through communication unit 30, the multi pack management unit 20 turns on the external switch unit M to initiate discharging of the parallel multi pack module MP.

For reference, an M+ signal and an M- signal output from the multi pack management unit 20 represent signals that control the on/off operation of the external high-potential switch M+ and the external low-potential switch M-, respectively. In addition, S1 to Sn signals output from the multi pack management unit 20 represent signals that controls the on/off operation of the first to n$^{th}$ switch units S1 to Sn.

The multi pack management unit 20 also controls the operation of the current sensors I1 to In, the voltage sensors V1 to Vn and the temperature sensors T1 to Tn included in the first to n$^{th}$ sensor units SU1 to SUn while the parallel multi pack module MP is being discharged, and periodically records the operation characteristic value of each battery pack received from the current sensors I1 to In, the voltage sensors V1 to Vn and the temperature sensors T1 to Tn in a storage unit 50.

Here, the operation characteristic value includes measured current values ($I_{pack,1}$ to $I_{pack,n}$), measured voltage values ($V_{pack,1}$ to $V_{pack,n}$) and measured temperature values ($T_{pack,1}$ to $T_{pack,2}$) of the first to n$^{th}$ battery packs P1 to Pn as shown in the figure.

The multi pack management unit 20 may also determine a SOC (State Of Charge) of each battery pack based on the operation characteristic values of the first to n$^{th}$ battery packs P1 to Pn.

For example, the multi pack management unit 20 may determine the SOC of the first to n$^{th}$ battery packs P1 to Pn by counting the measured current values ($I_{pack,1}$ to $I_{pack,n}$) of the first to n$^{th}$ battery packs P1 to Pn over time. The multi pack management unit 20 may measure the OCV of each battery pack using the first to n$^{th}$ voltage sensors V1 to Vn before initiating the discharging of the first to n$^{th}$ battery packs P1 to Pn, and determine an initial SOC of each battery pack by referring to an OCV-SOC look-up table to look up a SOC corresponding to the OCV. In addition, the multi pack management unit 20 may count the measured current values ($I_{pack,1}$ to $I_{pack,n}$) of the first to n$^{th}$ battery packs P1 to Pn based on the initial SOC over time to calculate the SOC and record the SOC in the storage unit 50. The OCV-SOC look-up table may be defined in advance and recorded in the storage unit 50.

As another example, the multi pack management unit 20 may determine the SOC of the first to n$^{th}$ battery packs P1 to Pn using the extended Kalman filter while the parallel multi pack module MP is being discharged. That is, the multi pack management unit 20 may determine the SOC of the first to n$^{th}$ battery packs P1 to Pn by inputting the operation characteristic value of each battery pack received from the first to n$^{th}$ sensor units SU1 to SUn into the extended Kalman filter coded in software, and record the same in the storage unit 50.

The extended Kalman filter is widely known in the technical field to which the present disclosure belongs. As an example, the extended Kalman filter may be an adaptive algorithm based on an equivalent circuit model or an electrochemical model.

The SOC estimation using the extended Kalman filter is disclosed in, for example, Gregory L. Plett's paper "Extended Kalman filtering for battery management totals of LiPB-based HEV battery packs, Parts 1, 2 and 3" (Journal of Power Source 134, 2004, 252-261), and this paper may be incorporated as a part of this specification.

Of course, the SOC may be determined using other known methods capable of determining SOC by utilizing the operation characteristic value of the battery pack, in addition to the current counting method or the extended Kalman filter described above.

In another aspect, the multi pack management unit 20 may count a measured current value measured in a specific voltage range among a plurality of measured current values for each battery pack recorded in the storage unit 50. In addition, the multi pack management unit 20 may determine a SOH (State Of Health) of each battery pack by referring to a current count value-SOH look-up table in which SOH according to the counted current value of a specific voltage range is defined in advance.

As another example, the multi pack management unit 20 may adaptively determine the SOH of the first to $n^{th}$ battery packs P1 to Pn using the extended Kalman filter while the parallel multi pack module MP is being discharged.

That is, the multi pack management unit 20 may determine the SOH of the first to $n^{th}$ battery packs P1 to Pn by inputting the operation characteristic value of each battery pack received from the first to $n^{th}$ sensor units SU1 to SUn into the extended Kalman filter coded in software.

The SOH estimation using the extended Kalman filter is disclosed in, for example, Korean Patent Registration No. 10-0818520, entitled "Apparatus, method, system and recording medium for estimating a current state and current parameters of an electrochemical cell", which may be incorporated as part of this specification.

Preferably, the multi pack management unit 20 may determine a pack resistance ($R_{pack,k}$; k is a battery pack index) of each battery pack based on the operation characteristic values of the first to $n^{th}$ battery packs P1 to Pn and record the same in the storage unit 50.

As an example, the multi pack management unit 20 may determine an I-V profile for each battery pack by means of linear regression analysis by using a plurality of measured current values and a plurality of measured voltage values for each battery pack recorded in the storage unit 50 while the parallel multi pack module MP is being discharged. Here, the plurality of measured current values and the plurality of measured voltage values are sampled for recent measured values based on a present time point. In addition, the multi pack management unit 20 may determine a slope of the I-V profile, calculate an absolute value of the slope as the pack resistance ($R_{pack,k}$) for each battery pack, and record the same in the storage unit 50. The slope of the I-V profile is an average ratio of the voltage change to the current change and is a factor corresponding to the resistance according to the Ohm's law.

As another example, the multi pack management unit 20 may refer to the present measured temperature value and SOC for each battery pack recorded in the storage unit 50 while the parallel multi pack module MP is being discharged to determine a pack resistance ($R_{pack,k}$) corresponding to the measured temperature value and SOC by looking up a SOC-temperature-pack resistance look-up table, and record the same in the storage unit 50. Here, the SOC-temperature-pack resistance look-up table has a data structure capable of looking up the pack resistance corresponding to SOC and temperature, and the SOC-temperature-pack resistance look-up table may be defined in advance and recorded in the storage unit 50.

The multi pack management unit 20 also determines an n number of available powers ($P_{pack,k}$; k is an integer of 1 to n) corresponding to the pack resistance ($R_{pack,k}$) of each battery pack by using pre-defined correlation information between pack resistance and available power, and determines min($P_{pack,k}$) corresponding to a minimum available power among the n number of available powers.

Preferably, the pre-defined correlation may be a pack resistance-available power look-up table capable of looking up the available power according to the pack resistance.

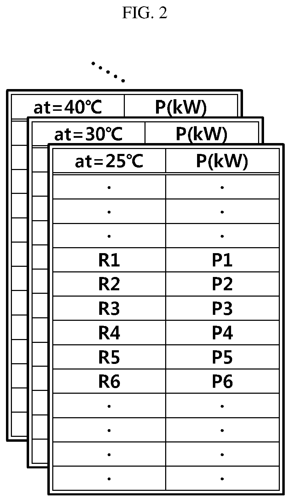

FIG. 2 is a diagram showing an example of a pack resistance-available power look-up table according to an embodiment of the present disclosure.

Referring to FIG. 2, the pack resistance-available power look-up table has a data structure capable of looking up the available power using the pack resistance, and may be defined in advance and recorded in the storage unit 50. It is preferable that the pack resistance-available power look-up table is provided independently according to the temperature of the battery pack. In this case, it may be considered that the available power varies according to the temperature of the battery pack. Preferably, the multi pack management unit 20 may identify the pack resistance-available power look-up table that is to be looked up using the measured temperature value of each battery pack, and determine the available power ($P_{pack,k}$) corresponding to the pack resistance ($R_{pack,k}$) using the identified look-up table.

More preferably, the pack resistance-available power look-up table may be provided independently for each SOH and temperature of the battery pack. In this case, it may be considered that the available power varies according to the temperature and SOH of the battery pack. Preferably, the multi pack management unit 20 may identify the pack resistance-available power look-up table that is to be looked up using the measured temperature value and SOH of each battery pack, and determine the available power ($P_{pack,k}$) corresponding to the pack resistance ($R_{pack,k}$) of each battery pack using the identified look-up table.

In another aspect, the multi pack management unit 20 may determine the available power for each battery pack using the I-V profile generated when determining the pack resistance ($R_{pack,k}$) of each battery pack.

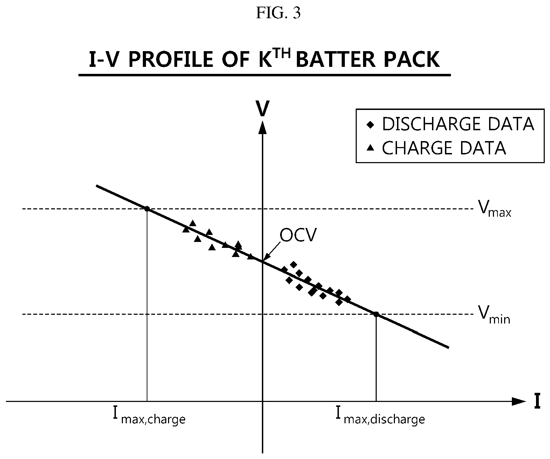

FIG. 3 is a graph showing an example of an I-V profile according to an embodiment of the present disclosure.

Referring to FIG. 3, the voltage at an intersection point where the I-V profile meets a V axis is an OCV (Open Circuit Voltage) corresponding to the SOC of the battery pack. Diamond dot marks indicate a plurality of measured voltage values and a plurality of measured current values measured when the parallel multi pack module MP is being discharged. Also, triangle dot marks indicate a plurality of measured voltage values and a plurality of measured current values measured when the parallel multi pack module MP is being charged. The I-V profile is a straight line generated by means of linear regression analysis for the plurality of measured voltage values and the plurality of measured current values. When the battery pack is being discharged, the measured current value is a positive value, and when the battery pack is being charged, the measured current value is a negative value. In addition, the absolute value of the slope of the I-V profile corresponds to the pack resistance ($R_{pack,k}$) of the battery pack.

When the parallel multi pack module MP is being discharged, the multi pack management unit 20 may determine a current value at an intersection where the I-V profile meets a straight line $V=V_{min}$ representing a discharge lower limit voltage as a maximum discharge current ($I_{max,discharge}$), and determine $V_{min}*|I_{max,discharge}|$ as the available power of the battery pack.

Meanwhile, when the parallel multi pack module MP is being charged, the multi pack management unit 20 may determine a current value at an intersection where the I-V profile generated to determine the pack resistance ($R_{pack,k}$) of each battery pack meets the line $V=V_{max}$ representing a charge upper limit voltage as a maximum charge current ($I_{max,charge}$), and determine $V_{max}*|I_{max,charge}|$ as the available power of the battery pack.

The multi pack management unit 20 determines the available powers ($P_{pack,k}$; k is 1 to n) of the first to $n^{th}$ battery packs P1 to Pn, then determines a minimum available power among the n number of available powers, and records the same in the storage unit 50.

The multi pack management unit 20 also adaptively determines the total power of the parallel multi pack module MP so that the pack power of the battery pack having a lowest pack resistance is identical to the minimum available power, and records the same in the storage unit 50.

Specifically, the multi pack management unit 20 may determine the total power ($P_{total}$) of the parallel multi pack module MP using Equation 1 below.

<Equation 1>

$$P_{total} = min(P_{pack,k})*I_{total}/max(I_{pack,k})$$

$$I_{total} = \sum_{k=1}^{n} I_{pack,k}$$

Here, k is an integer from 1 to n.

n is the number of battery packs.
$P_{total}$ is the total power of the parallel multi pack module MP.
$P_{pack,k}$ is an available power of a $k^{th}$ battery pack.
$I_{pack,k}$ is a measured current value of a $k^{th}$ battery pack.
$I_{total}$ is a current value of the parallel multi pack module MP. $I_{total}$ is a summed current value obtained by adding all measured current values ($I_{pack,1}$ to $I_{pack,n}$) of the first to $n^{th}$ battery packs P1 to Pn included in the parallel multi pack module MP.
max() is a function that returns a maximum value among a plurality of input variables. Therefore, $max(I_{pack,k})$ corresponds to a maximum current value among the measured current values ($I_{pack,1}$ to $I_{pack,n}$) of the first to $n^{th}$ battery packs P1 to Pn included in the parallel multi pack module MP.

If the total power ($P_{total}$) of the parallel multi pack module MP is determined according to Equation 1, an actual pack power of the battery pack having a lowest pack resistance ($R_{pack,k}$) becomes equal to the minimum available power $min(P_{pack,k})$ as described below. Here, the pack power means an actual power that each battery pack can provide when the parallel multi pack module MP is discharged, and it is a factor determined by the ratio of the pack resistance of each battery pack to the total resistance of the parallel multi pack module MP.

First, among the factors (terms) of Equation 1, if the denominator and numerator of '$I_{total}/max(I_{pack,k})$' are multiplied by '$V/\{I_{total}*max(I_{pack,k})\}$', this may be expressed as in Equation 2 below.

<Equation 2>

$$P_{total} = \min(P_{pack,k}) * I_{total}/\max(I_{pack,k})$$

$$= \min(P_{pack,k}) * \{V/\max(I_{pack,k})\}/\{V/I_{total}\}$$

In Equation 2, V is an output voltage of the parallel multi pack module MP, and it may be substantially the same as the measured voltage values ($V_{pack,1}$ to $V_{pack,n}$) of the first to $n^{th}$ battery packs P1 to Pn when the parallel multi pack module MP is being discharged or charged.

In Equation 2, '$V/\max(I_{pack,k})$' corresponds to $\min(R_{pack,k})$, which is a minimum resistance among the pack resistances of the first to $n^{th}$ battery packs P1 to Pn. This is because a maximum current flows through a battery pack having a minimum resistance when the output voltage of the parallel multi pack module MP is V. In addition, '$V/I_{total}$' corresponds to $R_{total}$, which is a total resistance of the parallel multi pack module MP. Therefore, Equation 2 may be converted into Equation 3.

<Equation 3>

$$P_{total} = \min(P_{pack,k}) * \min(R_{pack,k})/R_{total}$$

$R_{total}$ is an equivalent resistance to the pack resistances of the first to $n^{th}$ battery packs P1 to Pn connected in parallel, and corresponds to a total resistance of the parallel multi pack module MP. The pack resistances ($R_{pack,k}$) of the first to $n^{th}$ battery packs P1 to Pn and the total resistance $R_{total}$ of the -parallel multi pack module MP satisfy Equation 4 below.

<Equation 4>

$$R^{-1}{}_{total} = \sum_{k=1}^{n} R^{-1}{}_{pack,k}$$

Meanwhile, Equation 3 may be converted into an equation including the total power $\min(P_{pack,k}) * n$ of the parallel multi pack module MP determined according to the prior art as in Equation 5 below.

<Equation 5>

$$P_{total} = \min(P_{pack,k}) * \min(R_{pack,k})/R_{total}$$

$$= [\min(P_{pack,k}) * n] * \min(P_{pack,k}) * \min(R_{pack,k})/\{[\min(P_{pack,k}) * n] * R_{total}\}$$

$$= [\min(P_{pack,k}) * n] * \min(P_{pack,k})/\max(P_{pack,k})$$

In the second line of Equation 5 above, "$\min(R_{pack,k})/\{[\min(P_{pack,k}) * n] * R_{total}\}$" corresponds to a reciprocal of a pack power calculated for the battery pack having a lowest resistance among the first to $n^{th}$ battery packs P1 to Pn.

It is because the total power of the parallel multi pack module MP calculated according to the prior art is "$\min(P_{pack,k}) * n$", which is obtained by multiplying the minimum value "$\min(P_{pack,k})$" among the available powers of the first to $n^{th}$ battery packs P1 to Pn by the number n of battery packs, and the pack power of the battery pack having a lowest resistance corresponds to a value obtained by multiplying a resistance ratio "$R_{total}/\min(R_{pack,k})$" by the total power "$\min(P_{pack,k}) * n$" calculated using the available powers.

Since the pack power of the battery pack having a lowest resistance has a maximum value among the n number of pack powers, "$\min(R_{pack,k})/\{[\min(P_{pack,k}) * n] * R_{total}\}$" in the second line of Equation 5 may be replaced with $\max(P_{pack,k})^{-1}$, as finally arranged in the third line.

Here, the pack power means an actual power of each battery pack when the parallel multi pack module MP is discharged. The actual power may be calculated by multiplying the total power ($P_{total}$) of the parallel multi pack module MP by the ratio ($R_{total}/R_{pack,k}$) of the pack resistance ($R_{pack,k}$) of each battery pack to the total resistance ($R_{total}$) of the parallel multi pack module MP.

Seeing Equation 5, the total power ($P_{total}$) of the parallel multi pack module MP determined according to an embodiment of the present disclosure corresponds to a value obtained by multiplying the total power "$min(P_{pack,k})*n$" determined from the minimum available power of the first to $n^{th}$ battery packs P1 to Pn by an attenuation factor, namely "$min(P_{pack,k})/max(P_{pack,k})$". Here, "$min(P_{pack,k})/max(P_{pack,k})$" is a relative ratio between a maximum value and a minimum value among the available powers of the first to $n^{th}$ battery packs P1 to Pn and thus is always smaller than 1. Therefore, the total power of the parallel multi pack module MP determined according to the present disclosure is smaller than the total power determined from the minimum available power of the first to $n^{th}$ battery packs P1 to Pn by $[min(P_{pack,k})*n]*[1-min(P_{pack,k})/max(P_{pack,k})]$.

If the pack power ($P_{pack,Rmin}$) of the battery pack having a lowest pack resistance is calculated using the total power ($P_{total}$) determined by Equation 5, it is equal to the minimum available power among the available powers of the first to $n^{th}$ battery packs P1 to Pn as in Equation 6. Therefore, it is possible to fundamentally prevent the phenomenon that the battery pack having a lowest pack resistance is overcharged or overdischarged while the parallel multi pack module MP is being discharged.

<Equation 6>

$$P_{pack,Rmin} = P_{total}*R_{total}/min(R_{pack,k})$$

$$= \{min(P_{pack,k})*min(R_{pack,k})/R_{total}\}*\{R_{total}/min(R_{pack,k})\}$$

$$= min(P_{pack,k})$$

According to the present disclosure, when the total power ($P_{total}$) of the parallel multi pack module MP is determined according to Equation 1, the pack power ($P_{pack,Rmin}$) of the battery pack having a lowest pack resistance ($R_{pack,k}$) becomes equal to $min(P_{pack,k})$, which is a minimum available power.

In addition, in Equation 1, since the total power ($P_{total}$) of the parallel multi pack module MP is determined by $I_{total}$, which is a summed current value of the measured current values ($I_{pack,1}$ to $I_{pack,n}$) of the first to $n^{th}$ battery packs P1 to Pn, and $max(I_{pack,k})$, which is a maximum value of the measured current values ($I_{pack,1}$ to $I_{pack,n}$), and the measured current values ($I_{pack,1}$ to $I_{pack,n}$) are accurately measured through the first to $n^{th}$ current sensors I1 to In, there is an advantage that the total power ($P_{total}$) may be reliably determined through simple calculation.

Meanwhile, in Equation 1, $min(P_{pack,k})$ corresponding to the minimum available power of the first to $n^{th}$ battery packs P1 to Pn may be determined with reference to a SOC-available power look-up table. That is, after determining the SOCs of the first to $n^{th}$ battery packs P1 to Pn, the available power ($P_{pack,k}$) corresponding to the SOC of each battery pack may be mapped with reference to the SOC-available power look-up table, and a minimum value among the mapped available powers may be determined as $min(P_{pack,k})$. Here, the SOC-available power look-up table is a look-up table capable of mapping an available power according to the SOCs of the first to $n^{th}$ battery packs P1 to Pn, and may be predefined and recorded in the storage unit 50 in advance.

If $min(P_{pack,k})$ is determined with reference to the SOC-available power look-up table, this may replace the process of determining the pack resistances ($R_{pack,k}$) of the first to $n^{th}$ battery packs P1 to Pn using the I-V profile and determining an available power ($P_{pack,k}$) from the pack resistance ($R_{pack,k}$), thereby reducing the computational load for determining the minimum available power $min(P_{pack,k})$.

After determining the total power ($P_{total}$), the multi pack management unit 20 may transmit information on the total power ($P_{total}$) to the power management unit 40 of the electric-driven vehicle E through the communication unit 30.

Then, the power management unit 40 controls charging or discharging of the parallel multi pack module MP so that the power of the parallel multi pack module MP does not exceed the total power ($P_{total}$) determined by Equation 1. That is, the power management unit 40 controls the power consumption so that the power consumed in the load L does not exceed the total power ($P_{total}$) determined by Equation 1.

Specifically, the power management unit 40 adaptively distributes the power supplied to an inverter or a DC/DC converter corresponding to the load L and the power supplied to an electrical equipment unit and an ADAS (Advanced Driver Assistance System) unit, which supports functions of lane departure prevention, front collision warning or the like, so as not to exceed the total power ($P_{total}$) of the parallel multi pack module MP.

Meanwhile, if the load L is replaced by a charging device, the power management unit 40 may adaptively adjust the magnitude of the charging voltage and the charging current provided to the parallel multi pack module MP so as not to exceed the total power ($P_{total}$) determined by Equation 1 while the parallel multi pack module MP is being charged using the charging device.

Therefore, it is possible to prevent a battery pack having a low resistance among the battery packs of the parallel multi pack module MP from being overcharged or overdischarged, like the prior art.

In the present disclosure, there is no particular limitation on the type of the storage unit 50 as long as it is a storage medium capable of recording and erasing information. As an example, the storage unit 50 may be a RAM, a ROM, an EEPROM, a register, or a flash memory. The storage unit 50 may also be electrically connected to the multi pack management unit 20 through, for example, a data bus so as to be accessed by the multi pack management unit 20.

The storage unit 50 also stores and/or updates and/or erases and/or transmits a program including various control logics performed by the multi pack management unit 20, and/or data generated when the control logic is executed and look-up tables and parameters defined in advance. The storage unit 50 may be logically divided into two or more parts and may be included in the multi pack management unit 20 without limitation.

In the present disclosure, the multi pack management unit 20 and/or the power management unit 40 may optionally include a processor, an application-specific integrated circuit (ASIC), another chipset, a logic circuit, a register, a communication modem, a data processing device, or the like, known in the art to execute the various control logics described above. In addition, when the control logic is implemented in software, the multi pack management unit 20 and/or the power management unit 40 may be implemented as a set of program modules. At this time, the program module may be stored in a memory and executed by a processor. The memory may be provided inside or outside the processor and be connected to the processor through various well-known computer components. Also, the memory may be included in the storage unit 50 of the present disclosure. In addition, the memory refers to a device in which information is stored, regardless of the type of device, and does not refer to a specific memory device.

In addition, one or more of the various control logics of the multi pack management unit 20 and/or the power management unit 40 may be combined, and the combined control logics may be written in a computer-readable code system and recorded in a computer-readable recording medium. The recording medium is not particularly limited as long as it is accessible by a processor included in a computer. As an example, the storage medium includes at least one selected from the group consisting of a ROM, a RAM, a register, a CD-ROM, a magnetic tape, a hard disk, a floppy disk and an optical data recording device. The code scheme may be distributed to a networked computer to be stored and executed therein. In addition, functional programs, codes and code segments for implementing the combined control logics may be easily inferred by programmers in the art to which the present disclosure belongs.

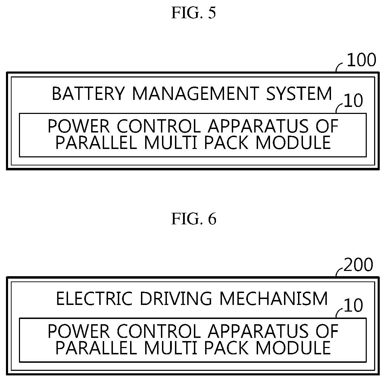

The power control apparatus 10 according to an embodiment of the present disclosure may be included in a battery management system 100 as shown in FIG. 5. The battery management system 100 controls the overall operation related to charging and discharging of a battery, and is a computing system called a battery management system (BMS) in the art.

In addition, the power control apparatus 10 according to an embodiment of the present disclosure may be mounted to various types of electric driving mechanism 200 as shown in FIG. 6, in addition to the electric-driven vehicle E.

The electric driving mechanism 200 may be an electric power device movable by electricity, such as an electric bicycle, an electric motorcycle, an electric train, an electric ship and an electric plane, or a power tool having a motor, such as an electric drill and an electric grinder.

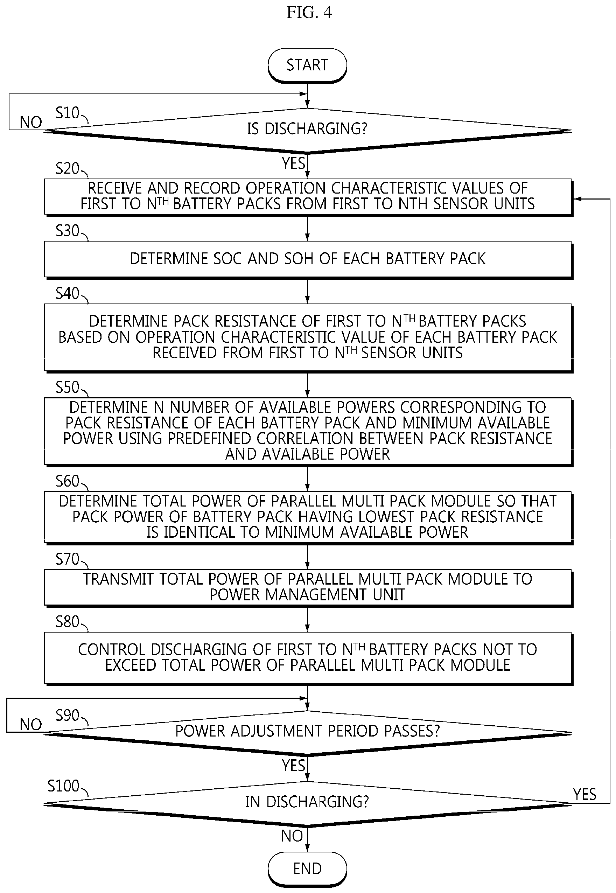

FIG. 4 is a flowchart for illustrating a method for controlling power of a parallel multi pack module MP according to an embodiment of the present disclosure.

As shown in FIG. 4, in Step S10, the multi pack management unit 20 determines whether the parallel multi pack module MP is in a discharge state. To this end, the multi pack management unit 20 may monitor measured current values ($I_{pack,1}$ to $I_{pack,n}$) measured using the first to $n^{th}$ current sensors I1 to In. If the measured current values ($I_{pack,1}$ to $I_{pack,n}$) are positive rather than 0, it may be determined that the parallel multi pack module MP is being discharged. If the determination result of Step S10 is YES, the multi pack management unit 20 proceeds to Step S20.

In Step S20, the multi pack management unit 20 controls the first to $n^{th}$ sensor units SU1 to SUn to receive the operation characteristic values of the first to $n^{th}$ battery packs P1 to Pn from the first to $n^{th}$ sensor units SU1 to SUn, and records the same in the storage unit 50.

In the present disclosure, the operation characteristic value includes measured voltage values ($V_{pack,1}$ to $V_{pack,n}$), measured current values ($I_{pack,1}$ to $I_{pack,n}$) and measured temperature values ($T_{pack,1}$ to $T_{pack,n}$) of each battery pack. Step S30 proceeds after Step S20.

In Step S30, the multi pack management unit 20 determines SOC and SOH of each battery pack. The method of determining SOC and SOH has already been described above. Step S40 proceeds after Step S30.

In Step S40, the multi pack management unit 20 determines the pack resistances ($R_{pack,k}$) of the first to $n^{th}$ battery packs P1 to Pn, respectively, based on the operation characteristic value of each battery pack received from the first to $n^{th}$ sensor units SU1 to SUn.

Preferably, the multi pack management unit 20 may generate an I-V profile for a plurality of measured voltage values and a plurality of measured current values recently sampled based on the present time point by means of linear regression analysis, and calculate the pack resistance ($R_{pack,k}$) of each battery pack from a slope of the I-V profile. Step S50 proceeds after Step S40.

In Step S50, the multi pack management unit 20 determines an n number of available powers ($P_{pack,k}$)

corresponding to the pack resistance ($R_{pack,k}$) of each battery pack using a pre-defined correlation between pack resistance and available power, and determines a minimum available power ($\min(P_{pack,k})$) among the n number of available powers.

In an example, the multi pack management unit 20 may look up an available power ($P_{pack,k}$) corresponding to the pack resistance ($R_{pack,k}$) of each battery pack using the pack resistance-available power look-up table recorded in advance in the storage unit 50.

Preferably, in determining the available power ($P_{pack,k}$) of each battery pack, the multi pack management unit 20 may identify the pack resistance-available power look-up table corresponding to the measured temperature value and SOH of the corresponding battery pack and look up an available power ($P_{pack,k}$) corresponding to the pack resistance ($R_{pack,k}$) using the identified pack resistance-available power look-up table.

In another example, the multi pack management unit 20 may determine a current at a point where the I-V profile used in calculating the pack resistance ($R_{pack,k}$) of each battery pack intersects with the straight line $V=V_{min}$ corresponding to a discharge lower limit voltage as a maximum discharge current $I_{max,discharge}$, and determine a value calculated by the equation $V=V_{min}*|I_{max,discharge}|$ as the available power ($P_{pack,k}$).

In another example, the multi pack management unit 20 may determine an available power ($P_{pack,k}$) of each battery pack by looking up an available power corresponding to the SOC of each battery pack with reference to the SOC-available power look-up table using the SOC of each battery pack. The SOC-available power look-up table may be defined according to the SOH and temperature of the battery pack. In this case, the multi pack management unit 20 may identify the SOC-available power look-up table corresponding to the SOH and the measured temperature value of each battery pack, and determine an available power of each battery pack with reference to the identified look-up table.

Step S60 proceeds after Step S50.

In Step S60, the multi pack management unit 20 determines the total power ($P_{total}$) of the parallel multi pack module so that the pack power of the battery pack having a lowest pack resistance ($R_{pack,k}$) is identical to the minimum available power using Equation 1 above. At this time, the multi pack management unit 20 may determine the total power ($P_{total}$) using the maximum value $\max(I_{pack,k})$ among the measured current values ($I_{pack,1}$ to $I_{pack,n}$) of the first to $n^{th}$ battery packs P1 to Pn and the summed current value ($I_{total}$) of the measured current values ($I_{pack,1}$ to $I_{pack,n}$). Since the measured current values ($I_{pack,1}$ to $I_{pack,n}$) may be accurately measured using the first to $n^{th}$ current sensors I1 to In, the total power ($P_{total}$) attenuated than the total power determined by the prior art may be reliably measured. Here, the total power $P_{total}$ has a magnitude attenuated by $[\min(P_{pack,k})*n]*[1-\min(P_{pack,k})/\max(P_{pack,k})]$ compared to the total power calculated according to the prior art. Step S70 proceeds after Step S60.

In Step S70, the multi pack management unit 20 transmits the total power ($P_{total}$) of the parallel multi pack module MP to the power management unit 40 of the electric-driven vehicle E through the communication unit 30. Step S80 proceeds after Step S70.

In Step S80, the power management unit 40 controls discharging of the parallel multi pack module MP so that the power of the parallel multi pack module MP does not exceed the total power ($P_{total}$) determined by Equation 1.

That is, the power management unit 40 controls the power consumption so that the power consumed in the load L does not exceed the total power ($P_{total}$) determined by Equation 1.

Specifically, the power management unit 40 adaptively distributes the power supplied to an inverter or a DC/DC converter corresponding to the load L and the power supplied to an electrical equipment unit and an ADAS (Advanced Driver Assistance System) unit, which supports functions of lane departure prevention, front collision warning or the like, so as not to exceed the total power ($P_{total}$) of the parallel multi pack module MP determined by Equation 1.

As a result, it is possible to fundamentally prevent the conventional problem that a battery pack having a low resistance among the battery packs of the parallel multi pack module MP is overcharged or overdischarged while the parallel multi pack module MP is being discharged.

Step S90 proceeds after Step S80.

In Step S90, the multi pack management unit 20 determines whether a preset power adjustment period passes. The power adjustment period is several ten msec to several seconds. If the determination result of Step S90 is NO, the multi pack management unit 20 holds progression of the process. Meanwhile, if the determination result of Step S90 is YES, the multi pack management unit 20 proceeds to S100.

In Step S100, the multi pack management unit 20 determines whether the parallel multi pack module MP is being discharged. To this end, the multi pack management unit 20 may monitor the measured current values ($I_{pack,1}$ to $I_{pack,n}$) measured using the first to $n^{th}$ current sensors I1 to In. If the measured current values are positive rather than 0, it may be determined that the parallel multi pack module MP is being discharged.

If the determination result of Step S100 is NO, the multi pack management unit 20 ends the execution of the power control method according to an embodiment of the present disclosure. Meanwhile, if the determination result of Step S100 is YES, the multi pack management unit 20 proceeds to Step S20. Therefore, the process of calculating the total power ($P_{total}$) of the parallel multi pack module MP and the process of controlling the discharging of the parallel multi pack module MP so as not to exceed the calculated total power ($P_{total}$) are repeated again.

Meanwhile, the power control method described above relates to a case where the parallel multi pack module MP is discharged. However, it is obvious to those skilled in the art that the present disclosure may also be applied even when the parallel multi pack module MP is being charged using a charging device.

According to the present disclosure, the total power of the parallel multi pack module is adjusted so that the pack power of the battery pack having a lowest resistance among the battery packs included in the parallel multi pack module becomes identical to a minimum available power among available powers of the battery packs, thereby fundamentally preventing the battery pack having a low resistance from being overcharged or overdischarged. As a result, safety and reliability of the parallel multi pack module may be improved compared to the prior art.

**Claims**

1. An apparatus (10) for controlling a power of a parallel multi pack module (MP), comprising:

   first to $n^{th}$ sensor units (SU1..SUn) configured to measure operation characteristic values including measured current values of first to $n^{th}$ battery packs (P1..Pn) that are included in the parallel multi pack module (MP) and connected to each other in parallel;
   a power management unit (40) configured to control a power consumed in a load (L) or a power provided to the parallel multi pack module (MP) by a charging device to correspond to a total power of the parallel multi pack module; and
   a multi pack management unit (20) operatively coupled to the first to $n^{th}$ sensor units and the power management unit (40),
   wherein the multi pack management unit (20) is configured to determine a minimum available power among the available powers of the first to $n^{th}$ battery packs (P1..Pn) based on the operation characteristic values of the first to $n^{th}$ battery packs (P1..Pn) received from the first to $n^{th}$ sensor units (SU1..SUn), determine a total power of the parallel multi pack module (MP) from the minimum available power and a ratio of a summed current value to a maximum current value among the measured current values of the first to $n^{th}$ battery packs (P1..Pn), and transmit a value of the determined total power of the parallel multi pack module (MP) to the power management unit (40), and
   the power management unit (40) is configured to control the power consumed in the load (L) or the power provided to the parallel multi pack module (MP) by the charging device to correspond to the total power of the parallel multi pack module (MP).

2. The apparatus (10) for controlling power of a parallel multi pack module (MP) according to claim 1,

   wherein the operation characteristic values further include measured voltage values of the first to $n^{th}$ battery packs (P1..Pn), and
   the multi pack management unit (20) is configured to:

   determine pack resistances of the first to $n^{th}$ battery packs (P1..Pn) from the measured current values and the measured voltage values of the first to $n^{th}$ battery packs (P1..Pn),
   determine an available power corresponding to the pack resistance with reference to a predetermined pack resistance-available power look-up table for each battery pack, and
   determine a minimum value among the available powers as the minimum available power.

3. The apparatus (10) for controlling power of a parallel multi pack module (MP) according to claim 2,
   wherein the multi pack management unit (20) is configured to:

   periodically receive a measured voltage value and a measured current value of each battery pack from the first to $n^{th}$ sensor units (SU1..SUn), and
   determine an average ratio of a voltage change to a current change calculated from the measured current values and the measured voltage values of the first to $n^{th}$ battery packs (P1..Pn) by means of linear regression analysis as the pack resistance of the first to $n^{th}$ battery packs (P1..Pn).

4. The apparatus (10) for controlling power of a parallel multi pack module (MP) according to claim 1,
   wherein the multi pack management unit (20) is configured to:

   determine a state of charge, SOC, of the first to $n^{th}$ battery packs (P1..Pn) based on the operation characteristic value of each battery pack received from the first to $n^{th}$ sensor units (SU1..SUn),
determine an available power corresponding to the SOCs of the first to $n^{th}$ battery packs (P1..Pn) with reference to a predefined SOC-available power look-up table, and
determine a minimum value among the available powers as the minimum available power.

5. The apparatus (10) for controlling power of a parallel multi pack module (MP) according to claim 1,
wherein the multi pack management unit (20) is configured to calculate the total power, $P_{total}$, of the parallel multi pack module (MP) using the following equation:

$$P_{total} = min(P_{pack,k})*I_{total}/max(I_{pack,k})$$

where: k is an integer from 1 to n; $min(P_{pack,k})$ corresponds to a minimum available power among the available powers of the first to $n^{th}$ battery packs; $I_{total}$ corresponds to a summed current value for the measured current values of the first to $n^{th}$ battery packs; and $max(I_{pack,k})$ corresponds to a maximum current value among the measured current values of the first to $n^{th}$ battery packs (P1..Pn).

6. The apparatus (10) for controlling power of a parallel multi pack module (MP) according to claim 1, further comprising:
a communication unit (30) interposed between the multi pack management unit (20) and the power management unit (40).

7. The apparatus (10) for controlling power of a parallel multi pack module (MP) according to claim 6,

wherein the parallel multi pack module (MP) is mounted to an electric-driven vehicle, and
the power management unit (40) is included in a control system of the electric-driven vehicle.

8. A battery management system, comprising the apparatus (10) for controlling power of a parallel multi pack module (MP) according to claim 1.

9. An electric driving mechanism, comprising the apparatus (10) for controlling power of a parallel multi pack module (MP) according to claim 1.

10. A method for controlling a power of a parallel multi pack module (MP), comprising:

(a) providing first to $n^{th}$ sensor units (SU1..SUn) configured to measure operation characteristic values including measured current values of first to $n^{th}$ battery packs (P1..Pn) that are included in the parallel multi pack module (MP) and connected to each other in parallel;
(b) determining (S50) an available power of each of the first to $n^{th}$ battery packs (P1..Pn) based on the operation characteristic value of each battery pack received from the first to $n^{th}$ sensor units (SU1.. SUn);
(c) determining (S50) a minimum available power among the available powers of the first to $n^{th}$ battery packs (P1..Pn);
(d) determining (S60)a total power of the parallel multi pack module (MP) from the minimum available power and a ratio of a summed current value to a maximum current value among the measured current values of the first to $n^{th}$ battery packs (P1..Pn); and
(e) controlling (S80) charging or discharging of the first to $n^{th}$ battery packs (P1..Pn) to correspond to the total power of the parallel multi pack module (MP).

11. The method for controlling power of a parallel multi pack module (MP) according to claim 10,

wherein the operation characteristic values further include measured voltage values of the first to $n^{th}$ battery packs (P1..Pn), and
the step (b) includes:

(b1) determining (S40) pack resistances of the first to $n^{th}$ battery packs (P1..Pn) from the measured current values and the measured voltage values of the first to $n^{th}$ battery packs,
(b2) determining an available power corresponding to the pack resistance with reference to a predetermined pack resistance-available power look-up table for each battery pack, and

(b3) determining a minimum value among the available powers as the minimum available power.

**12.** The method for controlling power of a parallel multi pack module (MP) according to claim 11, wherein the step (b) includes:

(b1) periodically receiving a measured voltage value and a measured current value of each battery pack from the first to n$^{th}$ sensor units, and
(b2) determining an average ratio of a voltage change to a current change calculated from the measured current values and the measured voltage values of the first to n$^{th}$ battery packs (P1..Pn) by means of linear regression analysis as the pack resistance of the first to n$^{th}$ battery packs (P1..Pn).

**13.** The method for controlling power of a parallel multi pack module (MP) according to claim 10, wherein the step (b) includes:

(b1) determining (S30) a SOC of the first to n$^{th}$ battery packs (P1..Pn) based on the operation characteristic value of each battery pack received from the first to n$^{th}$ sensor units (SU1..SUn),
(b2) determining an available power corresponding to the SOCs of the first to n$^{th}$ battery packs (P1..Pn) with reference to a predefined SOC-available power look-up table, and
(b3) determining a minimum value among the available powers as the minimum available power.

**14.** The method for controlling power of a parallel multi pack module (MP) according to claim 10,

Wherein in the step (d), the total power ($P_{total}$) of the parallel multi pack module (MP) is calculated using the following equation:

$$P_{total} = min(P_{pack,k}) * I_{total} / max(I_{pack,k})$$

where: k is an integer from 1 to n; $min(P_{pack,k})$ corresponds to a minimum available power among the available powers of the first to n$^{th}$ battery packs (P1..Pn); $I_{total}$ corresponds to a summed current value for the measured current values of the first to n$^{th}$ battery packs; and $max(I_{pack,k})$ corresponds to a maximum current value among the measured current values of the first to n$^{th}$ battery packs (P1..Pn).

**Patentansprüche**

**1.** Vorrichtung (10) zum Steuern einer Leistung eines parallelen Multipackmoduls (MP), umfassend:

erste bis n-te Sensoreinheiten (SU1... SUn), welche dazu eingerichtet sind, Betrieb-Charakteristik-Werte zu messen, welche gemessene Stromwerte von ersten bis n-ten Batteriepacks (P1...Pn) umfassen, welche in dem parallelen Multipackmodul (MP) umfasst sind und miteinander parallel geschalten sind;
eine Leistungsverwaltungseinheit (40), welche dazu eingerichtet ist, eine Leistung, welche in einer Last (L) verbraucht ist, oder eine Leistung zu steuern, welche dem parallelen Multipackmodul (MP) durch eine Ladevorrichtung bereitgestellt ist, um einer gesamten Leistung des parallelen Multipackmoduls zu entsprechen; und
eine Multipackverwaltungseinheit (20), welche mit den ersten bis n-ten Sensoreinheiten und der Leistungsverwaltungseinheit (40) betriebsfähig gekoppelt ist,
wobei die Multipackverwaltungseinheit (20) dazu eingerichtet ist, eine minimale verfügbare Leistung unter den verfügbaren Leistungen der ersten bis n-ten Batteriepacks (P1...Pn) zu bestimmen, auf Grundlage der Betrieb-Charakteristik-Werte der ersten bis n-ten Batteriepacks (P1... Pn), welche von den der ersten bis n-ten Sensoreinheiten (SU1... SUn) erhalten sind, eine gesamte Leistung des parallelen Multipackmoduls (MP) von der minimalen verfügbaren Leistung und einem Verhältnis eines summierten Stromwerts zu einem maximalen Stromwert unter den gemessenen Stromwerten der ersten bis n-ten Batteriepacks (P1... Pn) zu bestimmen, und einen Wert der bestimmten gesamten Leistung des parallelen Multipackmoduls (MP) zu der Leistungsverwaltungseinheit (40) zu übertragen, und
die Leistungsverwaltungseinheit (40) dazu eingerichtet ist, die Leistung, welche in der Last (L) verbraucht ist, oder die Leistung zu steuern, welche dem parallelen Multipackmodul (MP) durch die Ladevorrichtung bereitgestellt ist, um der gesamten Leistung des parallelen Multipackmoduls (MP) zu entsprechen.

2. Vorrichtung (10) zum Steuern einer Leistung eines parallelen Multipackmoduls (MP) nach Anspruch 1, wobei die Betrieb-Charakteristik-Werte ferner gemessene Spannungswerte der ersten bis n-ten Batteriepacks (P1... Pn) umfassen, und
die Multipackverwaltungseinheit (20) eingerichtet ist, zum:

> Bestimmen von Packwiderständen der ersten bis n-ten Batteriepacks (P1... Pn) von den gemessenen Stromwerten und den gemessenen Spannungswerten der ersten bis n-ten Batteriepacks (P1...Pn),
> Bestimmen einer verfügbaren Leistung, welche dem Packwiderstand in Bezug auf eine vorbestimmte packwiderstandsverfügbare Leistungsnachschlagetabelle für jedes Batteriepack entspricht, und
> Bestimmen eines minimalen Wertes unter den verfügbaren Leistungen als die minimale verfügbare Leistung.

3. Vorrichtung (10) zum Steuern einer Leistung eines parallelen Multipackmoduls (MP) nach Anspruch 2, wobei die Multipackverwaltungseinheit (20) eingerichtet ist, zum:

> periodischen Erhalten eines gemessenen Spannungswertes und eines gemessenen Stromwertes jedes Batteriepacks von den ersten bis n-ten Sensoreinheiten (SU1... SUn), und
> Bestimmen eines Durchschnittsverhältnisses einer Spannungsänderung zu einer Stromänderung, welche aus den gemessenen Stromwerten und den gemessenen Spannungswerten der ersten bis n-ten Batteriepacks (P1... Pn) mit Hilfe einer linearen Regressionsanalyse berechnet ist, als den Packwiderstand der ersten bis n-ten Batteriepacks (P1...Pn).

4. Vorrichtung (10) zum Steuern einer Leistung eines parallelen Multipackmoduls (MP) nach Anspruch 1, wobei die Multipackverwaltungseinheit (20) eingerichtet ist, zum:

> Bestimmen eines Ladezustands, SOC, der ersten bis n-ten Batteriepacks (P1...Pn) auf Grundlage des Betrieb-Charakteristik-Wertes jedes Batteriepacks, welcher von den ersten bis n-ten Sensoreinheiten (SU1... SUn) erhalten ist,
> Bestimmen einer verfügbaren Leistung, welche den SOCs der ersten bis n-ten Batteriepacks (P1...Pn) in Bezug auf eine vordefinierte SOC-verfügbare Leistungsnachschlagetabelle entspricht, und
> Bestimmen eines minimalen Wertes unter den verfügbaren Leistungen als die minimale verfügbare Leistung.

5. Vorrichtung (10) zum Steuern einer Leistung eines parallelen Multipackmoduls (MP) nach Anspruch 1, wobei die Multipackverwaltungseinheit (20) dazu eingerichtet ist, die gesamte Leistung, $P_{total}$, des parallelen Multipackmoduls (MP) unter Verwendung der folgenden Gleichung zu berechnen:

$$P_{total} = \min\left(P_{pack,k}\right) * I_{total}/\max\left(I_{pack,k}\right)$$

wobei k eine ganze Zahl von 1 bis n ist; $\min(P_{pack,k})$ einer minimalen verfügbaren Leistung unter den verfügbaren Leistungen der ersten bis n-ten Batteriepacks entspricht; $I_{total}$ einem summierten Stromwert für die gemessenen Stromwerte der ersten bis n-ten Batteriepacks entspricht; und $\max(I_{pack,k})$ einem maximalen Stromwert unter den gemessenen Stromwerten der ersten bis n-ten Batteriepacks (P1...Pn) entspricht.

6. Vorrichtung (10) zum Steuern einer Leistung eines parallelen Multipackmoduls (MP) nach Anspruch 1, ferner umfassend:
eine Kommunikationseinheit (30), welche zwischen die Multipackverwaltungseinheit (20) und die Leistungsverwaltungseinheit (40) eingefügt ist.

7. Vorrichtung (10) zum Steuern einer Leistung eines parallelen Multipackmoduls (MP) nach Anspruch 6, wobei das parallele Multipackmodul (MP) an einem elektrisch angetriebenen Fahrzeug angebracht ist, und
die Leistungsverwaltungseinheit (40) in einem Steuersystem des elektrisch angetriebenen Fahrzeugs umfasst ist.

8. Batterieverwaltungssystem, umfassend die Vorrichtung (10) zum Steuern einer Leistung eines parallelen Multipackmoduls (MP) nach Anspruch 1.

9. Elektrischer Antriebsmechanismus, umfassend die Vorrichtung (10) zum Steuern einer Leistung eines parallelen Multipackmoduls (MP) nach Anspruch 1.

**10.** Verfahren zum Steuern einer Leistung eines parallelen Multipackmoduls (MP), umfassend:

(a) Bereitstellen von ersten bis n-ten Sensoreinheiten (SU1... SUn), welche dazu eingerichtet sind, Betrieb-Charakteristik-Werte zu messen, welche gemessene Stromwerte von ersten bis n-ten Batteriepacks (P1...Pn) umfassen, welche in dem parallelen Multipackmodul (MP) umfasst werden und miteinander parallel geschalten werden;

(b) Bestimmen (S50) einer verfügbaren Leistung von jeder der ersten bis n-ten Batteriepacks (P1...Pn) auf Grundlage der Betrieb-Charakteristik-Werte jedes Batteriepacks, welche von der ersten bis n-ten Sensoreinheiten (SU1... SUn) erhalten werden;

(c) Bestimmen (S50) einer minimalen verfügbaren Leistung unter den verfügbaren Leistungen der ersten bis n-ten Batteriepacks (P1... Pn);

(d) Bestimmen (S60) einer gesamten Leistung des parallelen Multipackmoduls (MP) von der minimalen verfügbaren Leistung und eines Verhältnisses eines summierten Stromwertes zu einem maximalen Stromwert unter den gemessenen Stromwerten der ersten bis n-ten Batteriepacks (P1... Pn); und

(e) Steuern (S80) eines Ladens oder Entladens der ersten bis n-ten Batteriepacks (P1...Pn), um der gesamten Leistung des parallelen Multipackmoduls (MP) zu entsprechen.

**11.** Verfahren zum Steuern einer Leistung eines parallelen Multipackmoduls (MP) nach Anspruch 10, wobei die Betrieb-Charakteristik-Werte ferner gemessene Spannungswerte der ersten bis n-ten Batteriepacks (P1... Pn) umfassen, und
der Schritt (d) umfasst:

(b1) Bestimmen (S40) von Packwiderständen der ersten bis n-ten Batteriepacks (P1...Pn) von den gemessenen Stromwerten und den gemessenen Spannungswerten der ersten bis n-ten Batteriepacks,

(b2) Bestimmen einer verfügbaren Leistung, welche dem Packwiderstand in Bezug auf eine vorbestimmte packwiderstandsverfügbare Leistungsnachschlagetabelle für jeden Batteriepack entspricht, und

(b3) Bestimmen eines minimalen Wertes unter den verfügbaren Leistungen als die minimale verfügbare Leistung.

**12.** Verfahren zum Steuern einer Leistung eines parallelen Multipackmoduls (MP) nach Anspruch 11, wobei der Schritt (b) umfasst:

(b1) periodisches Erhalten eines gemessenen Spannungswertes und eines gemessenen Stromwertes jedes Batteriepacks von den ersten bis n-ten Sensoreinheiten, und

(b2) Bestimmen eines Durchschnittsverhältnisses einer Spannungsänderung zu einer Stromänderung, welche aus den gemessenen Stromwerten und den gemessenen Spannungswerten der ersten bis n-ten Batteriepacks (P1... Pn) mit Hilfe einer linearen Regressionsanalyse berechnet werden, als den Packwiderstand der ersten bis n-ten Batteriepacks (P1...Pn).

**13.** Verfahren zum Steuern einer Leistung eines parallelen Multipackmoduls (MP) nach Anspruch 10, wobei der Schritt (b) umfasst:

(b1) Bestimmen (S30) eines SOC der ersten bis n-ten Batteriepacks (P1...Pn) auf Grundlage des Betrieb-Charakteristik-Wertes jedes Batteriepacks, welcher von den ersten bis n-ten Sensoreinheiten (SU1... SUn) erhalten wird,

(b2) Bestimmen einer verfügbaren Leistung, welche den SOCs der ersten bis n-ten Batteriepacks (P1... Pn) in Bezug auf eine vordefinierte SOC-verfügbare Leistungsnachschlagetabelle entspricht, und

(b3) Bestimmen eines minimalen Wertes unter den verfügbaren Leistungen als die minimale verfügbare Leistung.

**14.** Verfahren zum Steuern einer Leistung eines parallelen Multipackmoduls (MP) nach Anspruch 10, wobei, in dem Schritt (d), die gesamte Leistung ($P_{total}$) des parallelen Multipackmoduls (MP) unter Verwendung der folgenden Gleichung berechnet wird:

$$P_{total} = \min\left(P_{pack,k}\right) * I_{total} / \max\left(I_{pack,k}\right)$$

wobei k eine ganze Zahl von 1 bis n ist; min($P_{pack,k}$) einer minimalen verfügbaren Leistung unter den verfügbaren Leistungen der ersten bis n-ten Batteriepacks (P1... Pn) entspricht; $I_{total}$ einem summierten Stromwert für die gemessenen Stromwerte der ersten bis n-ten Batteriepacks entspricht; und $max(I_{pack,k})$ einem maximalen Stromwert unter den gemessenen Stromwerten der ersten bis n-ten Batteriepacks (P1...Pn) entspricht.

**Revendications**

1. Appareil (10) de contrôle d'une puissance d'un module à blocs multiples parallèles (MP), comprenant :

   des première à n$^{ème}$ unités de capteur (SU1..SUn) configurées pour mesurer des valeurs caractéristiques de fonctionnement comportant des valeurs de courant mesurées de premier à n$^{ème}$ blocs-batteries (P1..Pn) qui sont compris dans le module à blocs multiples parallèles (MP) et connectés les uns aux autres en parallèle ;
   une unité de gestion de puissance (40) configurée pour contrôler une puissance consommée dans une charge (L) ou une puissance fournie au module à blocs multiples parallèles (MP) par un dispositif de recharge pour correspondre à une puissance totale du module à blocs multiples parallèles ; et
   une unité de gestion de blocs multiples (20) couplée de manière fonctionnelle aux première à n$^{ème}$ unités de capteur et à l'unité de gestion de puissance (40),
   dans lequel l'unité de gestion de blocs multiples (20) est configurée pour déterminer une puissance disponible minimale parmi les puissances disponibles des premier à n$^{ème}$ blocs-batteries (P1..Pn) sur la base des valeurs caractéristiques de fonctionnement des premier à n$^{ème}$ blocs-batteries (P1..Pn) reçues en provenance des première à n$^{ème}$ unités de capteur (SU1..SUn), déterminer une puissance totale du module à blocs multiples parallèles (MP) à partir de la puissance disponible minimale et d'un rapport d'une valeur de courant totalisée sur une valeur de courant maximale parmi les valeurs de courant mesurées des premier à n$^{ème}$ blocs-batteries (P1..Pn), et émettre une valeur de la puissance totale déterminée du module à blocs multiples parallèles (MP) vers l'unité de gestion de puissance (40), et
   l'unité de gestion de puissance (40) est configurée pour contrôler la puissance consommée dans la charge (L) ou la puissance fournie au module à blocs multiples parallèles (MP) par le dispositif de recharge pour correspondre à la puissance totale du module à blocs multiples parallèles (MP).

2. Appareil (10) de contrôle de puissance d'un module à blocs multiples parallèles (MP) selon la revendication 1,

   dans lequel les valeurs caractéristiques de fonctionnement comportent en outre des valeurs de tension mesurées des premier à n$^{ème}$ blocs-batteries (P1..Pn), et
   l'unité de gestion de blocs multiples (20) est configurée pour :

   déterminer des résistances de bloc des premier à n$^{ème}$ blocs-batteries (P1..Pn) à partir des valeurs de courant mesurées et des valeurs de tension mesurées des premier à n$^{ème}$ blocs-batteries (P1..Pn),
   déterminer une puissance disponible correspondant à la résistance de bloc en référence à une table de consultation prédéterminée entre la résistance de bloc et la puissance disponible pour chaque bloc-batterie, et
   déterminer une valeur minimale parmi les puissances disponibles comme étant la puissance disponible minimale.

3. Appareil (10) de contrôle de puissance d'un module à blocs multiples parallèles (MP) selon la revendication 2, dans lequel l'unité de gestion de blocs multiples (20) est configurée pour :

   recevoir périodiquement une valeur de tension mesurée et une valeur de courant mesurée de chaque bloc-batterie en provenance des première à n$^{ème}$ unités de capteur (SU1..SUn), et
   déterminer un rapport moyen d'un changement de tension sur un changement de courant calculé à partir des valeurs de courant mesurées et des valeurs de tension mesurées des premier à n$^{ème}$ blocs-batteries (P1..Pn) au moyen d'une analyse par régression linéaire comme étant la résistance de bloc des premier à n$^{ème}$ blocs-batteries (P1..Pn).

4. Appareil (10) de contrôle de puissance d'un module à blocs multiples parallèles (MP) selon la revendication 1, dans lequel l'unité de gestion de blocs multiples (20) est configurée pour :

   déterminer un état de charge, SOC, des premier à n$^{ème}$ blocs-batteries (P1..Pn) sur la base de la valeur caractéristique de fonctionnement de chaque bloc-batterie reçue en provenance des première à n$^{ème}$ unités de capteur (SU1..SUn),

déterminer une puissance disponible correspondant aux SOC des premier à n$^{ème}$ blocs-batteries (P1..Pn) en référence à une table de consultation prédéfinie entre le SOC et la puissance disponible, et

déterminer une valeur minimale parmi les puissances disponibles comme étant la puissance disponible minimale.

5. Appareil (10) de contrôle de puissance d'un module à blocs multiples parallèles (MP) selon la revendication 1,

dans lequel l'unité de gestion de blocs multiples (20) est configurée pour calculer la puissance totale, P$_{total}$, du module à blocs multiples parallèles (MP) à l'aide de l'équation suivante :

$$P_{total} = min(P_{pack,k}) * I_{total} / max(I_{pack,k})$$

où : k est un nombre entier de 1 à n ; $min(P_{pack,k})$ correspond à une puissance disponible minimale parmi les puissances disponibles des premier à n$^{ème}$ blocs-batteries ; $I_{total}$ correspond à une valeur de courant totalisée pour les valeurs de courant mesurées des premier à n$^{ème}$ blocs-batteries ; et $max(I_{pack,k})$ correspond à une valeur de courant maximale parmi les valeurs de courant mesurées des premier à n$^{ème}$ blocs-batteries (P1..Pn).

6. Appareil (10) de contrôle de puissance d'un module à blocs multiples parallèles (MP) selon la revendication 1, comprenant en outre :
une unité de communication (30) interposée entre l'unité de gestion de blocs multiples (20) et l'unité de gestion de puissance (40).

7. Appareil (10) de contrôle de puissance d'un module à blocs multiples parallèles (MP) selon la revendication 6,

dans lequel le module à blocs multiples parallèles (MP) est monté sur un véhicule à propulsion électrique, et l'unité de gestion de puissance (40) est comprise dans un système de contrôle du véhicule à propulsion électrique.

8. Système de gestion de batterie, comprenant l'appareil (10) de contrôle de puissance d'un module à blocs multiples parallèles (MP) selon la revendication 1.

9. Mécanisme de propulsion électrique, comprenant l'appareil (10) de contrôle de puissance d'un module à blocs multiples parallèles (MP) selon la revendication 1.

10. Procédé de contrôle d'une puissance d'un module à blocs multiples parallèles (MP), comprenant :

(a) la fourniture de première à n$^{ème}$ unités de capteur (SU1..SUn) configurées pour mesurer des valeurs caractéristiques de fonctionnement comportant des valeurs de courant mesurées de premier à n$^{ème}$ blocs-batteries (P1..Pn) qui sont compris dans le module à blocs multiples parallèles (MP) et connectés les uns aux autres en parallèle ;

(b) la détermination (S50) d'une puissance disponible de chacun des premier à n$^{ème}$ blocs-batteries (P1..Pn) sur la base de la valeur caractéristique de fonctionnement de chaque bloc-batterie reçue en provenance des première à n$^{ème}$ unités de capteur (SU1..SUn) ;

(c) la détermination (S50) d'une puissance disponible minimale parmi les puissances disponibles des premier à n$^{ème}$ blocs-batteries (P1..Pn) ;

(d) la détermination (S60) d'une puissance totale du module à blocs multiples parallèles (MP) à partir de la puissance disponible minimale et d'un rapport d'une valeur de courant totalisée sur une valeur de courant maximale parmi les valeurs de courant mesurées des premier à n$^{ème}$ blocs-batteries (P1..Pn) ; et

(e) le contrôle (S80) de la recharge ou de la décharge des premier à n$^{ème}$ blocs-batteries (P1..Pn) pour correspondre à la puissance totale du module à blocs multiples parallèles (MP).

11. Procédé de contrôle de puissance d'un module à blocs multiples parallèles (MP) selon la revendication 10,

dans lequel les valeurs caractéristiques de fonctionnement comportent en outre des valeurs de tension mesurées des premier à n$^{ème}$ blocs-batteries (P1..Pn), et
l'étape (b) comporte :

(b1) la détermination (S40) de résistances de bloc des premier à nᵉᵐᵉ blocs-batteries (P1..Pn) à partir des valeurs de courant mesurées et des valeurs de tension mesurées des premier à nᵉᵐᵉ blocs-batteries,
(b2) la détermination d'une puissance disponible correspondant à la résistance de bloc en référence à une table de consultation prédéterminée entre la résistance de bloc et la puissance disponible pour chaque bloc-batterie, et
(b3) la détermination d'une valeur minimale parmi les puissances disponibles comme étant la puissance disponible minimale.

12. Procédé de contrôle de puissance d'un module à blocs multiples parallèles (MP) selon la revendication 11, dans lequel l'étape (b) comporte :

(b1) la réception, de manière périodique, d'une valeur de tension mesurée et une valeur de courant mesurée de chaque bloc-batterie en provenance des première à nᵉᵐᵉ unités de capteur, et
(b2) la détermination d'un rapport moyen d'un changement de tension sur un changement de courant calculé à partir des valeurs de courant mesurées et des valeurs de tension mesurées des premier à nᵉᵐᵉ blocs-batteries (P1..Pn) au moyen d'une analyse par régression linéaire comme étant la résistance de bloc des premier à nᵉᵐᵉ blocs-batteries (P1..Pn).

13. Procédé de contrôle de puissance d'un module à blocs multiples parallèles (MP) selon la revendication 10, dans lequel l'étape (b) comporte :

(b1) la détermination (S30) d'un SOC des premier à nᵉᵐᵉ blocs-batteries (P1..Pn) sur la base de la valeur caractéristique de fonctionnement de chaque bloc-batterie reçue en provenance des première à nᵉᵐᵉ unités de capteur (SU1..SUn),
(b2) la détermination d'une puissance disponible correspondant aux SOC des premier à nᵉᵐᵉ blocs-batteries (P1..Pn) en référence à une table de consultation prédéfinie entre le SOC et la puissance disponible, et
(b3) la détermination d'une valeur minimale parmi les puissances disponibles comme étant la puissance disponible minimale.

14. Procédé de contrôle de puissance d'un module à blocs multiples parallèles (MP) selon la revendication 10,

dans lequel à l'étape (d), la puissance totale ($P_{total}$) du module à blocs multiples parallèles (MP) est calculée à l'aide de l'équation suivante :

$$P_{total} = min(P_{pack,k}) * I_{total} / max(I_{pack,k})$$

où : k est un nombre entier de 1 à n ; $min(P_{pack,k})$ correspond à une puissance disponible minimale parmi les puissances disponibles des premier à nᵉᵐᵉ blocs-batteries (P1..Pn) ; $I_{total}$ correspond à une valeur de courant totalisée pour les valeurs de courant mesurées des premier à nᵉᵐᵉ blocs-batteries ; et $max(I_{pack,k})$ correspond à une valeur de courant maximale parmi les valeurs de courant mesurées des premier à nᵉᵐᵉ blocs-batteries (P1..Pn).

FIG. 1

FIG. 2

| at=40℃ | P(kW) |
|---|---|
| at=30℃ | P(kW) |

| at=25℃ | P(kW) |
|---|---|
| . | . |
| . | . |
| . | . |
| R1 | P1 |
| R2 | P2 |
| R3 | P3 |
| R4 | P4 |
| R5 | P5 |
| R6 | P6 |
| . | . |
| . | . |
| . | . |
| . | . |

FIG. 3

## I-V PROFILE OF K$^{TH}$ BATTER PACK

FIG. 4

```
                        ┌─────────┐
                        │  START  │
                        └────┬────┘
                             │
              ┌──────────────▼──────────────────────────┐
  NO    S10   ◁           IS DISCHARGING?               ▷
              └──────────────┬──────────────────────────┘
                           YES│
  S20   ┌──────────────────────▼──────────────────────────────────┐
        │ RECEIVE AND RECORD OPERATION CHARACTERISTIC VALUES OF    │
        │ FIRST TO N^TH BATTERY PACKS FROM FIRST TO NTH SENSOR UNITS│
        └──────────────────────┬──────────────────────────────────┘
  S30   ┌──────────────────────▼──────────────────────────────────┐
        │     DETERMINE SOC AND SOH OF EACH BATTERY PACK           │
        └──────────────────────┬──────────────────────────────────┘
  S40   ┌──────────────────────▼──────────────────────────────────┐
        │ DETERMINE PACK RESISTANCE OF FIRST TO N^TH BATTERY PACKS │
        │ BASED ON OPERATION CHARACTERISTIC VALUE OF EACH BATTERY  │
        │ PACK RECEIVED FROM FIRST TO N^TH SENSOR UNITS            │
        └──────────────────────┬──────────────────────────────────┘
  S50   ┌──────────────────────▼──────────────────────────────────┐
        │ DETERMINE N NUMBER OF AVAILABLE POWERS CORRESPONDING TO  │
        │ PACK RESISTANCE OF EACH BATTERY PACK AND MINIMUM         │
        │ AVAILABLE POWER USING PREDEFINED CORRELATION BETWEEN     │
        │ PACK RESISTANCE AND AVAILABLE POWER                      │
        └──────────────────────┬──────────────────────────────────┘
  S60   ┌──────────────────────▼──────────────────────────────────┐
        │ DETERMINE TOTAL POWER OF PARALLEL MULTI PACK MODULE SO   │
        │ THAT PACK POWER OF BATTERY PACK HAVING LOWEST PACK       │
        │ RESISTANCE IS IDENTICAL TO MINIMUM AVAILABLE POWER       │
        └──────────────────────┬──────────────────────────────────┘
  S70   ┌──────────────────────▼──────────────────────────────────┐
        │ TRANSMIT TOTAL POWER OF PARALLEL MULTI PACK MODULE TO    │
        │ POWER MANAGEMENT UNIT                                    │
        └──────────────────────┬──────────────────────────────────┘
  S80   ┌──────────────────────▼──────────────────────────────────┐
        │ CONTROL DISCHARGING OF FIRST TO N^TH BATTERY PACKS NOT   │
        │ TO EXCEED TOTAL POWER OF PARALLEL MULTI PACK MODULE      │
        └──────────────────────┬──────────────────────────────────┘
                               │
              ┌────────────────▼─────────────────────────┐
  NO    S90   ◁      POWER ADJUSTMENT PERIOD PASSES?     ▷
              └────────────────┬─────────────────────────┘
                             YES│
              ┌────────────────▼─────────────────────────┐
  S100        ◁           IN DISCHARGING?               ▷  YES
              └────────────────┬─────────────────────────┘
                             NO│
                        ┌──────▼──────┐
                        │     END     │
                        └─────────────┘
```

FIG. 5

```
                                              100
┌──────────────────────────────────────────────┐
│  BATTERY MANAGEMENT SYSTEM    10               │
│  ┌──────────────────────────────────────────┐ │
│  │  POWER CONTROL APPARATUS OF              │ │
│  │  PARALLEL MULTI PACK MODULE             │ │
│  └──────────────────────────────────────────┘ │
└──────────────────────────────────────────────┘
```

FIG. 6

```
                                              200
┌──────────────────────────────────────────────┐
│  ELECTRIC DRIVING MECHANISM   10               │
│  ┌──────────────────────────────────────────┐ │
│  │  POWER CONTROL APPARATUS OF              │ │
│  │  PARALLEL MULTI PACK MODULE             │ │
│  └──────────────────────────────────────────┘ │
└──────────────────────────────────────────────┘
```

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020200090585
- US 2020185944 A1
- US 2018026311 A1
- KR 100818520

**Non-patent literature cited in the description**

- *Journal of Power Source*, 2004, vol. 134, 252-261